# EUROPEAN PATENT APPLICATION

(11) **EP 4 741 526 A1**
(43) Date of publication of application: **13.05.2026**
(21) Application number: 23921611.2
(22) Date of filing: 21.11.2023
(51) Int. Cl.: C23C 14/56, C23C 14/54, C23C 14/34

(54) **WIRE ROD DEPOSITION DEVICE**

(30) Priority: 07.07.2023 KR 20230088550
(71) Applicant: Maru L&C Co., Ltd., Daegu 42702 (KR)
(72) Inventor: KIM, Dong Jin, Daegu 42702 (KR)
(74) Representative: Zacco Sweden AB
(86) International application number: PCT/KR2023/095095
(87) International publication number: WO 2025/014017

(57) **Abstract**

The present invention relates to a wire rod deposition device including a plurality of roller parts which move a wire rod wound thereon, a heater part that is intensively heats the wire rod passing over the roller parts, a cathode part that provides a deposition material to the wire rod, and an attachment preventing part that covers an outside of the wire rod except for a deposition space of the wire rod and prevents attachment of scattered particles.

## Description

### [Technical Field]

The present invention relates to a wire rod deposition device, and more particularly, to a wire rod deposition device that allows materials to reach a wire rod surface in a set area and obtain high thin film quality while having a certain orientation.

### [Background Art]

Generally, as expectations for the commercialization of superconducting application technologies using high-temperature superconductors increase, R&D for high-temperature superconducting wire rods is actively conducted worldwide.

Methods of manufacturing the high-temperature superconducting wire rods include a first generation high-temperature superconducting wire rod manufacturing method using a powder-in-tube (PIT) process of filling a precursor powder into an Ag pipe and processing the precursor powder, and a second generation high-temperature superconducting wire rod manufacturing method of manufacturing a high-temperature superconducting wire rod called a coated conductor (CC).

The CC, which is a second generation high-temperature superconducting wire rod, is being researched and developed by many research institutes and companies around the world, is manufactured using various methods, and has a more complex multi-layer structure than the first generation high-temperature superconducting wire rod.

Meanwhile, in the related art, in a process of heating the wire rod at a high temperature, a roller on which the wire rod is wound is damaged, and thus wire rod deposition defects frequently occur. Therefore, it is required to solve this problem.

The background technology of the present invention is disclosed in Korean Patent No. 10-0910613 (registered on July 28, 2009, Title of Invention: Apparatus for continuous fabrication of superconducting tapes).

### [Disclosure]

### [Technical Problem]

The present invention is created to solve the above problems, and the present invention is directed to providing a wire rod deposition device that allows materials to reach a wire rod surface in a set area and obtain high thin film quality while having a certain orientation.

### [Technical Solution]

A wire rod deposition device according to the present invention includes a plurality of roller parts which move a wire rod wound thereon, a heater part that intensively heats the wire rod passing over the roller parts, a cathode part that provides a deposition material to the wire rod, and an attachment preventing part that covers an outside of the wire rod except for a deposition space of the wire rod and prevents attachment of scattered particles.

The heater part may include a first heater portion disposed above the wire rod and heated when power is applied thereto, and one or more first heat blocking portions that cover the first heater portion such that only a lower portion thereof under the first heater portion is open to emit heat.

The heater part may include a second heater portion disposed above the wire rod and heated as a lamp is turned on when power is applied thereto, a second reflective portion that covers the second heater portion such that only a lower portion thereof under the second heater portion is open and reflects heat generated by the second heater portion, and a second cooling portion that is in contact with the second reflective portion and cools the second reflective portion as a coolant flows therethrough.

The heater part may include an upper heater portion that is disposed above the wire rod and generates heat, an upper reflective portion that covers the upper heater portion such that only a lower portion thereof under the upper heater portion is open and reflects heat generated by the upper heater portion, an upper cooling portion that cools the upper reflective portion, a lower heat blocking portion that is disposed between the wire rod and the cathode part and induces heat to be focused on the wire rod, and a lower cooling portion that cools the lower heat blocking portion.

The lower heat blocking portion may include a plurality of heat blocking center portions that have through-hole portions formed in centers thereof and are stacked on the lower cooling portion, and a plurality of heat blocking side portions that cover edges of the heat blocking center portions.

The heat blocking center portion may include a center plate portion having the through-hole portion formed at a center thereof, a plurality of center fixing hole portions formed in the center plate portion, and a center support portion that is mounted on the lower cooling portion through the center fixing hole portions and supports the center plate portion.

The center support portion may fix a center of the center plate portion, and the center fixing hole portion may have a rectangular hole shape of which a length increases from the center to an end portion of the center plate portion.

The wire rod deposition device according to the present invention may further include a cooling part that is disposed between the heater part and the roller part and cools the wire rod while in direct contact with the wire rod.

### [Advantageous Effects]

In a wire rod deposition device according to the present invention, a wire rod can be heated by a heater part, wound on a plurality of roller parts and moved to be deposited, the heater part can intensively heat the wire rod to prevent damage to surrounding facilities, and an attachment preventing part can cover a portion of the wire rod to prevent scattered particles from being attached to the wire rod.

### [Description of Drawings]

FIG. 1 is a schematic view illustrating a wire rod deposition device according to an embodiment of the present invention.
FIG. 2 is a schematic view illustrating a roller part according to an embodiment of the present invention.
FIG. 3 is a schematic view illustrating a roller holding portion according to an embodiment of the present invention.
FIG. 4 is a schematic view illustrating a cooling part according to an embodiment of the present invention.
FIG. 5 is a schematic view illustrating an attachment preventing part according to an embodiment of the present invention.
FIG. 6 is a schematic view illustrating a heater part according to a first embodiment of the present invention.
FIG. 7 is a schematic view illustrating a heater part according to a second embodiment of the present invention.
FIG. 8 is a schematic view illustrating a heater part according to a third embodiment of the present invention.
FIG. 9 is a schematic view illustrating a lower heat blocking portion according to the third embodiment of the present invention.
FIG. 10 is a schematic view illustrating a cathode part according to an embodiment of the present invention.

### [Modes of the Invention]

Hereinafter, embodiments of a wire rod deposition device according to the present invention will be described with reference to the accompanying drawings. In this process, the thicknesses of lines or the sizes of components illustrated in the drawings may be exaggerated for clarity and convenience of description. Further, terms described below are defined in consideration of functions in the present invention and may change according to the intention or custom of a user or an operator. Therefore, definitions of these terms should be made based on the contents throughout the present specification.

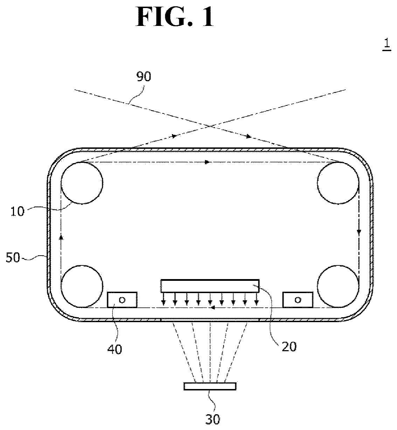

FIG. 1 is a schematic view illustrating a wire rod deposition device according to an embodiment of the present invention. Referring to FIG. 1, a wire rod deposition device 1 according to the embodiment of the present invention includes roller parts 10, a heater part 20, and a cathode part 30.

A wire rod 90 may be wound on two or more roller parts 10 and moved. The roller part 10 may have a length that is changeable on an axis thereof, and malfunction thereof may be prevented even when the roller part 10 is heated by the heater part 20. As an example, a pair of roller parts 10 may be arranged to face each other, or three or more roller parts 10 may be arranged. The wire rod 90 may be deposited while repeatedly passing over each of the roller parts 10 several times.

The heater part 20 may heat the wire rod 90 passing over the roller part 10. As an example, the heater part 20 may be disposed between the roller parts 10 and heat the wire rod 90 passing over the roller parts 10 from above.

The cathode part 30 may provide a deposition material onto the wire rod 90. As an example, the roller part 10, the heater part 20, and the cathode part 30 may be embedded in a chamber that may be converted into a vacuum state. The cathode part 30 may be embedded in the chamber and include a cathode providing portion that provides a deposition material, a cathode gas portion that supplies gas to the chamber, and a cathode power portion that supplies power to the chamber.

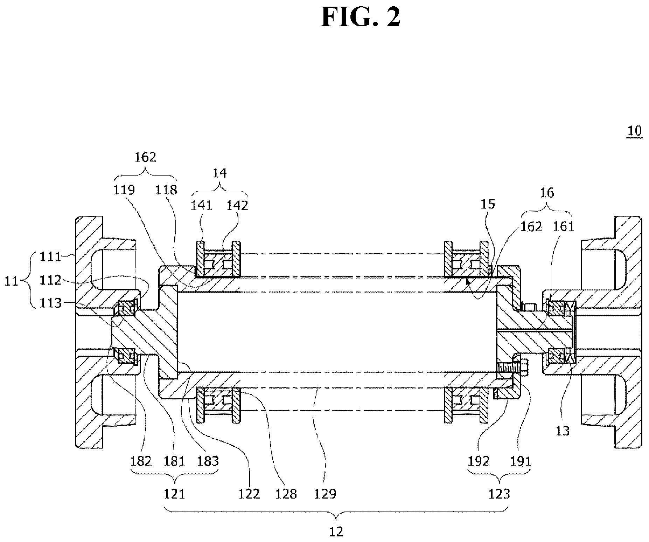

FIG. 2 is a schematic view illustrating a roller part according to an embodiment of the present invention. Referring to FIG. 2, the roller part 10 according to the embodiment of the present invention may include a roller support portion 11, a roller shaft portion 12, and a roller absorbing portion 13.

The roller support portion 11 may be fixedly installed in the chamber. As an example, the roller support portion 11 may include a pair of first roller support portions 111 fixedly installed in the chamber to face each other and second roller support portions 112 which are formed in the first roller support portions 111 and into which the roller shaft portion 12 may be inserted.

The second roller support portion 112 may form a hole at the center of the first roller support portion 111. A third roller support portion 113 may be mounted on the second roller support portion 112. The third roller support portion 113 may be a bearing.

The roller shaft portion 12 may be rotatably mounted on the roller support portion 11. As an example, both end portions of the roller shaft portion 12 may be inserted into the second roller support portions 112, and the roller shaft portion 12 may be rotated while supported by the third roller support portion 113. The roller shaft portion 12 may pass through the third roller support portion 113. The roller shaft portion 12 may be supported on the third roller support portion 113 that is movable from the second roller support portion 112.

The roller absorbing portion 13 may be disposed between the roller support portion 11 and the roller shaft portion 12 and absorb expansion of the roller shaft portion 12. As an example, the roller absorbing portion 13 may be embedded into the second roller support portion 112 and support the roller shaft portion 12.

The roller shaft portion 12 may pass through the roller absorbing portion 13. A spare space may be formed in the second roller support portion 112 by the roller absorbing portion 13. When the roller shaft portion 12 is heated and expanded in length, the roller absorbing portion 13 may contract. The roller absorbing portion 13 may be in close contact with the third roller support portion 113.

In more detail, the roller shaft portion 12 may include a shaft rotating portion 121, a shaft connecting portion 122, and a shaft coupling portion 123.

The shaft rotating portion 121 may be rotatably mounted on the roller support portion 11. The pair of shaft rotating portions 121 may be spaced apart from each other and mounted on the roller support portion 11.

As an example, the shaft rotating portion 121 may include a first shaft rotating portion 181 inserted in the second roller support portion 112 and caught by the third roller support portion 113, a second shaft rotating portion 182 extending from one end portion of the first shaft rotating portion 181, inserted into the third roller support portion 113, and rotatably supported on the third roller support portion 113, and a third shaft rotating portion 183 extending outward from the other end portion of the first shaft rotating portion 181.

The first shaft rotating portion 181 and the second shaft rotating portion 182 may each have a cylindrical shape. The third shaft rotating portion 183 may be formed on an end portion of the first shaft rotating portion 181 and may have a disk shape. A diameter of the third shaft rotating portion 183 may be greater than a diameter of the first shaft rotating portion 181. A diameter of the second shaft rotating portion 182 may be smaller than the diameter of the first shaft rotating portion 181.

The shaft connecting portion 122 may connect the pair of shaft rotating portions 121. As an example, the shaft connecting portion 122 may have a cylindrical shape having an empty interior, and steps may be formed at the shaft connecting portion 122 so that both end portions thereof are fixedly caught by edges of the second shaft rotating portion 182.

The shaft coupling portion 123 may couple the shaft rotating portion 121 and the shaft connecting portion 122. As an example, the shaft coupling portion 123 may include a first shaft coupling portion 191 disposed to face the second shaft rotating portion 182 and a second shaft coupling portion 192 bent from the first shaft coupling portion 191 and covering an end portion of the shaft connecting portion 122.

The shaft coupling portion 123 may be arranged at one end portion or both end portions of the shaft connecting portion 122. The third shaft rotating portion 183 may be coupled to the first shaft coupling portion 191 using a bolt.

The wire rod 90 may be wound directly on an outer circumferential surface of the shaft connecting portion 122 and moved. In addition, a roller adding support portion 14 mounted on the shaft connecting portion 122 and moved while the wire rod 90 is wound thereon and a roller adding absorbing portion 15 maintaining a spare space of the shaft connecting portion 122 may be additionally mounted. When these components are added, operability of the wire rod 90 may be ensured using a double bearing method.

The one or more roller adding support portions 14 may be arranged in a longitudinal direction of the shaft connecting portion 122 and support the wire rod 90. As an example, the roller adding support portion 14 may include a pair of first adding support portions 141 having a ring shape and a second adding support portion 142 disposed between the first adding support portions 141.

An outer diameter of the first adding support portion 141 is larger than an outer diameter of the second adding support portion 142. Accordingly, when the wire rod 90 is seated on the second adding support portion 142, separation of the wire rod 90 may be prevented by the first adding support portions 141 arranged on both sides thereof.

The second adding support portion 142 may be a bearing. The wire rod 90 may be seated on the second adding support portion 142, and friction generated while the wire rod 90 moves may be suppressed. The roller adding support portions 14 may be consecutively disposed according to a width of the wire rod 90 or the number of times the wire rod 90 is wound on the roller part 10. When the roller adding support portions 14 are consecutively disposed, the first adding support portion 141 and the second adding support portion 142 may be alternately arranged.

A shaft mounting portion 129 may be formed on an outer circumferential surface of the shaft connecting portion 122. The shaft mounting portion 129 may have a groove shape recessed to have a smaller outer diameter than the shaft connecting portion 122.

The shaft mounting portion 129 may extend from a set point to an end portion of the shaft connecting portion 122, and the roller adding support portion 14 may be inserted from the end to the set point. A shaft step portion 128 may be formed at the set point so that the roller adding support portion 14 is caught and supported thereon.

The roller adding absorbing portion 15 may be disposed between the roller adding support portion 14 and the shaft coupling portion 123 and absorb expansion of the roller adding support portion 14. As an example, the roller adding absorbing portion 15 may be disposed between the shaft coupling portion 123 and the roller adding support portion 14, which is disposed at an edge thereof, among the roller adding support portions 14 consecutively arranged.

The roller adding absorbing portion 15 may be optionally disposed between the roller adding support portions 14 arranged in a row. That is, the roller adding absorbing portion 15 may be disposed between the pair of first adding support portions 141 facing each other.

The roller absorbing portion 13 and the roller adding absorbing portion 15 may be wave washers or disk springs. For example, the roller absorbing portion 13 and the roller adding absorbing portion 15 may be wave washers or disk springs.

One of the roller absorbing portion 13 and the roller adding absorbing portion 15 may be a wave washer, and the other one thereof may be a disk spring. When the shaft connecting portion 122 expands, the roller absorbing portion 13 may contract to secure a space for the expansion of the shaft connecting portion 122. When the roller adding support portion 14 adjacent to the roller adding absorbing portion 15 expands, the roller adding absorbing portion 15 may contract to secure a space for the expansion of the roller adding support portion 14.

The roller part 10 according to the embodiment of the present invention may further include a roller discharge portion 16. The roller discharge portion 16 may discharge gas that is not discharged during a vacuum process and remains in the roller shaft portion 12.

As an example, the roller discharge portion 16 may include a first discharge portion 161 that discharges gas remaining inside the shaft connecting portion 122 and a second discharge portion 162 that discharges gas remaining between the roller connecting portion 122 and the roller adding support portion 14.

The first discharge portion 161 may have a shape of a hole passing through the first shaft rotating portion 181 and the second shaft rotating portion 182. In addition, the first discharge portion 161 may have a shape of a hole passing through the third shaft rotating portion 183 and the first shaft coupling portion 191. The first discharge portion 161 may discharge the gas inside the shaft connecting portion 122.

The second discharge portion 162 may include a second discharge mounting groove portion 119 that forms a groove for movement of gas in a longitudinal direction of the shaft mounting portion 129 and a second discharge step groove portion 118 formed in the shaft step portion 128 and communicating with the second discharge mounting groove portion 119. The second discharge portion 162 may be provided as a plurality of second discharge portions 162, which are formed in a circumferential direction of the shaft mounting portion 129.

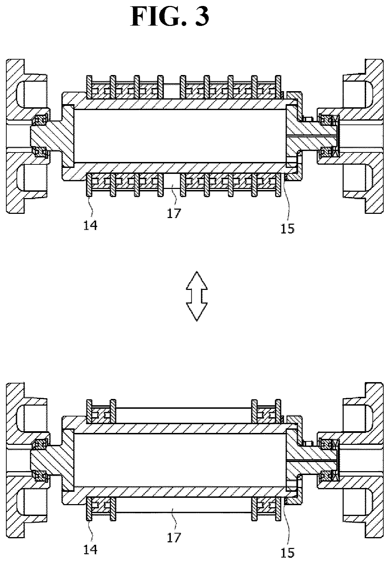

FIG. 3 is a schematic view illustrating a roller holding portion according to an embodiment of the present invention. Referring to FIG. 3, the roller part 10 according to the embodiment of the present invention may further include a roller holding portion 17.

The roller holding portion 17 may be disposed between the roller adding support portions 14 and cover a space formed in the shaft connecting portion 122 so that the roller adding support portion 14 is in close contact with the roller adding absorbing portion 15. The number of the roller adding support portions 14 may be changed according to a working environment, and when the number of the installed roller adding support portions 14 decreases, the roller holding portion 17 may cover a remaining space.

That is, when four roller adding support portions 14 are used and then two roller adding support portions 14 are used instead of the four roller adding support portions 14, the roller holding portion 17 corresponding to the two roller adding support portions 14 is mounted on the shaft connecting portion 122. Accordingly, the roller adding support portion 14 and the roller adding absorbing portion 15 may be maintained in a close contact state.

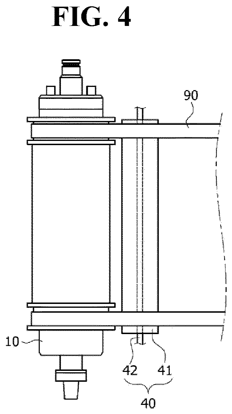

FIG. 4 is a schematic view illustrating a cooling part according to an embodiment of the present invention. Referring to FIGS. 1 and 4, the wire rod deposition device 1 according to the embodiment of the present invention may further include a cooling part 40.

The cooling part 40 may cool the wire rod 90. The cooling part 40 may cool the wire rod 90 heated by the heater part 20 and thus suppress heating of the roller part 10 by the wire rod 90. The cooling part 40 may be disposed between the heater part 20 and the roller part 10 and in direct contact with the wire rod 90.

The cooling part 40 may include a cooling block portion 41 fixedly installed on the chamber and in contact with the wire rod 90 and a cooling circulating portion 42 that circulates a coolant in the cooling block portion 41 to cool the cooling block portion 41.

The cooling part 40 may be additionally disposed between the roller part 10 and the heater part 20 that guide the wire rod 90 not passing through the heater part 20, to cool the wire rod 90. Meanwhile, the cooling circulating portion 42 may supply a coolant to the roller part 10 to directly cool the roller part 10.

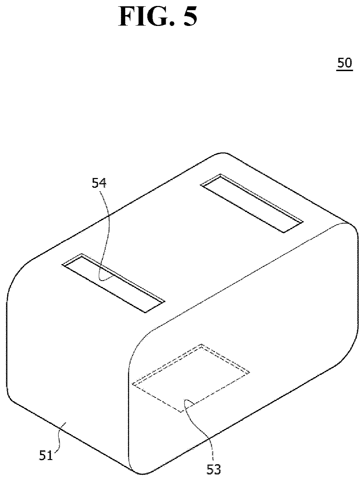

FIG. 5 is a schematic view illustrating an attachment preventing part according to the embodiment of the present invention. Referring to FIGS. 1 and 5, the wire rod deposition device 1 according to the embodiment of the present invention may further include an attachment preventing part 50.

The attachment preventing part 50 may cover an outside of the wire rod 90 except for a deposition space of the wire rod 90 and prevent scattered particles from being attached to the wire rod 90 outside the deposition space. As an example, the attachment preventing part 50 may include a prevention box portion 51 having a box shape surrounding the roller part 10 and the heater part 20.

A prevention deposition hole portion 53 for deposition may be formed in a lower portion of the prevention box portion 51, and a prevention passage hole portion 54 may be formed in an upper portion of the prevention box portion 51 through which the wire rod 90 passes. The prevention box portion 51 may be disassembled or assembled and may be fixedly installed in the chamber through a separate support.

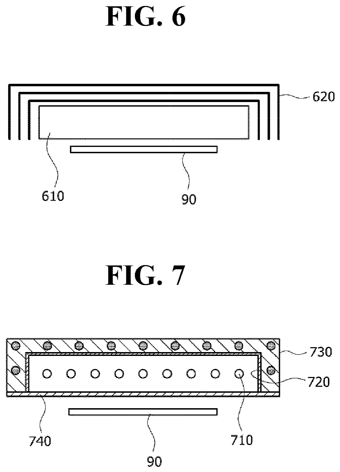

FIG. 6 is a schematic view illustrating a heater part according to a first embodiment of the present invention. Referring to FIG. 6, the heater part 20 according to the first embodiment of the present invention may include a first heater portion 610 and a first heat blocking portion 620.

The first heater portion 610 may be disposed above the wire rod 90 and heated when power is applied thereto. A sheath heater, a ceramic mold heater, or a PTC heater may be used as the first heater portion 610.

One or more first heat blocking portions 620 may cover the first heater portion 610 so that only a lower portion thereof under the first heater portion 610 is open to emit heat. The first heat blocking portion 620 may cover the first heater portion 610 so that heating is focused on the wire rod 90 passing through the lower portion of the first heater portion 610, and may prevent radiant heat from being transferred to a periphery of the first heater portion 610.

FIG. 7 is a schematic view illustrating a heater part according to a second embodiment of the present invention. Referring to FIG. 7, the heater part 20 according to the second embodiment of the present invention may include a second heater portion 710, a second reflective portion 720, and a second cooling portion 730.

The second heater portion 710 may be disposed above the wire rod 90 and heated as a lamp is turned on when power is applied thereto. As an example, a halogen lamp may be used as the second heater portion 710. The second heater portion 710 may be provided as a plurality of second heater portions 710, which are arranged to cross an upper portion of the wire rod 90.

The second reflective portion 720 may cover the second heater portion 710 such that only a lower portion thereof under the second heater portion 710 is open. The second reflective portion 720 may reflect heat generated by the second heater portion 710. The second heater portion 710 may be mounted on the second reflective portion 720. In addition, the second heater portion 710 may be mounted on the second cooling portion 730.

The second cooling portion 730 may be in contact with the second reflective portion 720, a coolant may flow therethrough, and thus the second reflective portion 720 may be cooled. The second cooling portion 730 may be fixedly installed in the chamber by a separate fixing part.

The second reflective portion 720 may be attached to or applied on an inner wall of the second cooling portion 730. An infrared reflector formed by coating the inner wall of the second cooling portion 730 with a gold material may be used as the second reflective portion 720.

A second transmission portion 740 may cover a lower portion of the second cooling portion 730 and transmit the heat generated by the second heater portion 710.

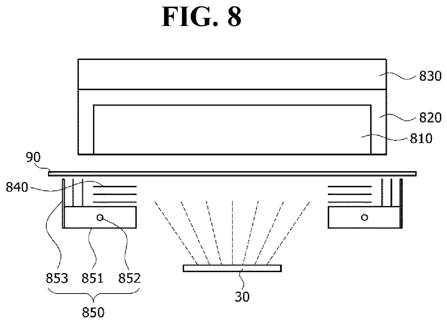

FIG. 8 is a schematic view illustrating a heater part according to a third embodiment of the present invention. Referring to FIG. 8, the heater part 20 according to a third embodiment of the present invention may include an upper heater portion 810, an upper reflective portion 820, an upper cooling portion 830, a lower heat blocking portion 840, and a lower cooling portion 850.

The upper heater portion 810 may be disposed above the wire rod 90 and generate heat. As an example, the first heater portion 610 of FIG. 6 or the second heater portion 710 of FIG. 7 may be used as the upper heater portion 810, and various heaters for heating the wire rod 90 may be applied thereto.

The upper reflective portion 820 may cover the upper heater portion 810 such that only a lower portion thereof under the upper heater portion 810 is open. The upper reflective portion 820 may reflect heat generated by the upper heater portion 810. The upper heater portion 810 may be mounted on the upper reflective portion 820. The upper reflective portion 810 may be mounted on the upper cooling portion 830.

The upper cooling portion 830 may be in contact with the upper reflective portion 820, a coolant may flow therethrough, and thus the upper reflective portion 820 may be cooled. The upper cooling portion 830 may be fixedly installed in the chamber by a separate fixing part. The upper reflective portion 820 may be attached to or applied on an inner wall of the upper cooling portion 830.

The lower heat blocking portion 840 may be disposed between the wire rod 90 and the cathode part 30 and induce heat to be focused on the wire rod 90. As an example, the lower heat blocking portion 840 may be provided as a plurality of lower heat blocking portions 840, which are stacked, and heat may be transferred through the lower heat blocking portions 840 being stacked. The lower heat blocking portion 840 may prevent radiant heat from the upper heater portion 810 from being transmitted to surrounding facilities.

The lower cooling portion 850 may cool the lower heat blocking portion 840. As an example, the heat transferred through the lower heat blocking portion 840 may be cooled through the lower cooling portion 850. The lower cooling portion 850 may have a hole formed at the center thereof so that the upper heater portion 810, the wire rod 90, and the cathode part 30 may be arranged to face each other in a vertical line.

The lower cooling portion 850 may include a lower cooling block portion 851, a lower cooling circulating portion 852 that induces circulation of a coolant in the lower cooling block portion 851, and a lower cooling partition wall portion 853 coupled to an edge of the lower cooling block portion 851.

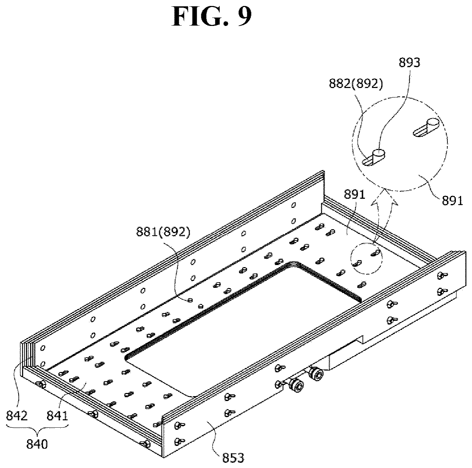

FIG. 9 is a schematic view illustrating a lower heat blocking portion according to the third embodiment of the present invention. Referring to FIG. 9, the lower heat blocking portion 840 according to the third embodiment of the present invention may include a heat blocking center portion 841 and a heat blocking side portion 842.

The heat blocking center portion 841 may be provided as a plurality of heat blocking center portions 841, which have through-hole portions 849 formed in centers thereof and are stacked on the lower cooling portion 850. As an example, the heat blocking center portions 841 may be vertically stacked on the lower cooling block portion 851.

The heat blocking side portion 842 may be provided as a plurality of heat blocking side portions 842, which cover edges of the heat blocking center portions 841. As an example, the plurality of heat blocking side portions 842 arranged in a horizontal direction may be in close contact with the lower cooling partition wall portion 853 and fixedly installed in the lower cooling partition wall portion 853 by a fixing part.

In more detail, the heat blocking center portion 841 may include a center plate portion 891, a center fixing hole portion 892, and a center support portion 893.

The center plate portion 891 may have the through-hole portion 849 formed at the center thereof. As an example, the center plate portion 891 may have a rectangular plate shape and may be provided as a plurality of center plate portions 891, which are stacked on the lower cooling block portion 851.

The center fixing hole portion 892 may be formed in each of the center plate portions 891. As an example, the center fixing hole portion 892 may include a first fixing hole portion 881 disposed at a center of the center plate portion 891 having a rectangular plate shape, and second fixing hole portions 882 arranged on both left and right sides of the first fixing hole portion 881.

The center support portion 893 may pass through the center fixing hole portion 892, may be mounted on the lower cooling portion 850, and may support the center plate portion 891. As an example, the center support portion 893 may be a pin or bolt that is mounted on the lower cooling blocking portion 851 and protrudes upward, and a nut may be selectively coupled thereto to fix the center plate portion 891.

The center support portion 893 may fix a central portion of the center plate portion 891, and the center fixing hole portion 892 may have a rectangular hole shape of which a length increases from the center to an end portion of the center plate portion 891.

The first fixing hole portion 881 may be formed in a size corresponding to the center support portion 893, and the center of the center plate portion 891 in which the first fixing hole portion 881 is formed may be fixed by the center support portion 893.

The second fixing hole portions 882 may be provided as a plurality of second fixing hole portions 882, which are formed on both left and right sides of the first fixing hole portion 881. The second fixing hole portion 882 may have a rectangular hole length that increases from the first fixing hole portion 881 to both left and right sides of the center plate portion 891. Accordingly, even when the center plate portion 891 is heated and expanded, interference with the center support portion 893 may be prevented.

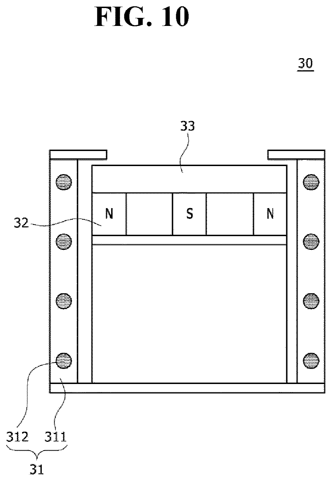

FIG. 10 is a schematic view illustrating a cathode part according to an embodiment of the present invention. Referring to FIG. 10, the cathode part 30 according to the embodiment of the present invention may include a cathode cooling portion 31, a cathode magnet portion 32, and a cathode material portion 33.

In the cathode cooling portion 31, a cathode passage portion 312 may be formed in the cathode block portion 311, and thus a coolant may circulate therethrough. In this case, the cathode passage portion 312 may be formed integrally with the cathode block portion 311 through a gun drill method and a welding process, thereby improving thermal conductivity.

The cathode cooling portion 31 may have a shape having an open upper side, the cathode magnet portion 32 may be embedded in the cathode cooling portion 31 and provide a magnetic force, and the cathode material portion 33 may be exposed to the outside from an upper surface of the cathode magnet portion 32 and provide a deposition material.

An operation of the wire rod deposition device having the above structure according to the embodiment of the present invention will be described below.

The wire rod 90 input into the chamber is wound on the plurality of roller parts 10 several times and moved, the wire rod 90 disposed between the roller parts 10 is heated by the heater part 20, and the material provided from the cathode part 30 is deposited on the wire rod 90.

When the roller part 10 is heated by the heater part 20, the roller shaft portion 12 expands, and the roller absorbing portion 13 contracts to support the expanded roller shaft portion 12.

When the roller adding support portion 14 expands, the roller adding absorbing portion 15 contracts to support the expanded roller adding support portion 14. In this case, the roller shaft portion 12 and the roller adding support portion 14 surrounding the roller shaft portion 12 may be provided with bearings, and thus the operability of the wire rod 90 may be ensured.

The roller discharge portion 16 may guide gas remaining inside the roller part 10 to be stably discharged, and the roller holding portion 17 may serve as a space, in which the roller adding support portion 14 is removed, depending on a working environment.

The heater part 20 is disposed above the wire rod 90 and adopts a heat blocking and reflecting structure that intensively supplies heat to the wire rod 90 moving downward and suppresses transfer of radiant heat to other facilities.

The plurality of lower heat blocking portions 840 are designed to be stacked. Centers of the plurality of lower heat blocking portions 840 are fixed, and a length of the center fixing hole portion 892 formed in the lower heat blocking portion 840 increases from the center to an edge of the lower heat blocking portion 840. Accordingly, even when the lower heat blocking portion 840 expands due to a high temperature of the upper heater portion 810, a mounting state may be stably maintained.

The cooling part 40 may be disposed between the roller part 10 and the heater part 20, may be in direct contact with the heated wire rod 90 to cool the wire rod 90, and thus may prevent overheating of the roller part 10 on which the wire rod 90 is wound. The cooling parts 40 may be arranged on both left and right sides of the heater part 20, and as needed, a coolant of the cooling parts 40 may pass through the roller part 10 and directly cool the roller part 10.

The attachment preventing part 50 is disposed to surround the entire outside of the wire rod 90 except for the deposition space of the wire rod 90. Accordingly, evaporated particles scattered in the cathode part 30 are prevented from being attached to the wire rod 90 in areas except for the deposition space.

In the wire rod deposition device 1 according to the embodiment of the present invention, the wire rod 90 may be deposited while heated by the heater part 20, wound on the plurality of roller parts 10, and moved. Further, the heater part 20 may intensively heat the wire rod 90 to prevent damage to the surrounding facilities, and the attachment preventing part 50 may partially cover the wire rod 90 to prevent scattered particles from being attached to the wire rod 90.

Although the present invention has been described with reference to embodiments illustrated in the drawings, the description is merely illustrative, and those skilled in the art to which the technology belongs could understand that various modifications and other equivalent embodiments may be made. Thus, the true technical scope of the present invention should be determined by the appended claims.

## Claims

1. A wire rod deposition device comprising:
a plurality of roller parts which move a wire rod wound thereon;
a heater part configured to intensively heat the wire rod passing over the roller parts;
a cathode part configured to provide a deposition material onto the wire rod; and
an attachment preventing part configured to cover an outside of the wire rod except for a deposition space of the wire rod and prevent attachment of scattered particles.

2. The wire rod deposition device of claim 1, wherein the heater part includes:
a first heater portion disposed above the wire rod and heated when power is applied thereto; and
one or more first heat blocking portions configured to cover the first heater portion such that only a lower portion thereof under the first heater portion is open to emit heat.

3. The wire rod deposition device of claim 1, wherein the heater part includes:
a second heater portion disposed above the wire rod and heated as a lamp is turned on when power is applied thereto;
a second reflective portion configured to cover the second heater portion such that only a lower portion thereof under the second heater portion is open and reflect heat generated by the second heater portion; and
a second cooling portion that is in contact with the second reflective portion and cools the second reflective portion as a coolant flows therethrough.

4. The wire rod deposition device of claim 1, wherein the heater part includes:
an upper heater portion disposed above the wire rod and configured to generate heat;
an upper reflective portion configured to cover the upper heater portion such that only a lower portion thereof under the upper heater portion is open and reflect heat generated by the upper heater portion;
an upper cooling portion configured to cool the upper reflective portion;
a lower heat blocking portion disposed between the wire rod and the cathode part and configured to induce heat to be focused on the wire rod; and
a lower cooling portion configured to cool the lower heat blocking portion.

5. The wire rod deposition device of claim 4, wherein the lower heat blocking portion includes:
a plurality of heat blocking center portions that have through-hole portions formed in centers thereof and are stacked on the lower cooling portion; and
a plurality of heat blocking side portions configured to cover edges of the heat blocking center portions.

6. The wire rod deposition device of claim 5, wherein the heat blocking center portion includes:
a center plate portion having the through-hole portion formed at a center thereof;
a plurality of center fixing hole portions formed in the center plate portion; and
a center support portion mounted on the lower cooling portion through the center fixing hole portions and configured to support the center plate portion.

7. The wire rod deposition device of claim 6, wherein the center support portion fixes a center of the center plate portion, and
wherein the center fixing hole portion has a rectangular hole shape of which a length increases from the center to an end portion of the center plate portion.

8. The wire rod deposition device of claim 1, further comprising a cooling part disposed between the heater part and the roller part and configured to cool the wire rod while in direct contact with the wire rod.
